(19) Europäisches Patentamt / European Patent Office / Office européen des brevets

(11) **EP 3 171 189 A1**

(12) **EUROPEAN PATENT APPLICATION**

(43) Date of publication:
24.05.2017 Bulletin 2017/21

(51) Int Cl.:
*G01R 33/06* (2006.01)     *G01R 33/18* (2006.01)

(21) Application number: 15195921.0

(22) Date of filing: 23.11.2015

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(71) Applicants:
• **Consejo Superior de Investigaciones Cientificas (CSIC)**
28006 Madrid (ES)
• **Slovak University of Technology in Bratislava**
812 43 Bratislava (SK)

• **Helmholtz-Zentrum Dresden - Rossendorf e.V.**
01328 Dresden (DE)

(72) Inventors:
• **Vázquez Villalabeitia, Manuel**
28049 Cantoblanco (MADRID) (ES)
• **Kolesar, Vladimir**
812  43 BRATISLAVA (SK)
• **Bali, Rantej**
01326 DRESDEN (DE)

(74) Representative: **Pons**
Glorieta Ruben Dario 4
28010 Madrid (ES)

(54) **PROCEDURE AND APPARATUS FOR MEASURING A D.C. MAGNETIC FIELD BASED ON MAGNETOSTRICTIVE EFFECT IN MAGNETIC WIRES**

(57)     The present invention relates to a procedure for measuring a d.c. magnetic field by means of a cylindrical device formed by a magnetostrictive core. A d.c. magnetic field is applied and the mechanical deformation on the device caused by the magnetic field is measured and compared with the obtained measurements from previous calibrations to estimate magnetic field intensity values.

The invention also relates to an apparatus for measuring a d.c. magnetic field by means of the indicated procedure. The apparatus comprises:

- a cylindrical sensor element and an abutment/fixing element, such that the cylindrical sensor element experiences mechanical deformation when exposed to the d.c. magnetic field,
- a deformation sensing device configured for detecting the mechanical deformation of the cylindrical sensor element, and
- a processing unit configured for determining the intensity of the d.c. magnetic field based on the detected mechanical deformation of the cylindrical sensor element.

EP 3 171 189 A1

## Description

## OBJECT OF THE INVENTION

A first object of the present invention is a procedure and apparatus for measuring a d.c. magnetic field by means of a cylindrical device formed by a magnetostrictive core with a diameter ranging between 1 and 20 μm and a Pyrex coating with a thickness ranging between 2 and 10 μm.

A d.c. magnetic field is applied on said device and the mechanical deformation on the device caused by the magnetic field is measured and compared with the obtained measurements from previous calibrations to estimate magnetic field intensity values.

In a first operation mode, one end of the cylindrical device is fixed while its second end is connected on movable or free contact.

In a second operation mode, both ends of the cylindrical device are fixed.

A second object of the present invention is an apparatus for measuring a d.c. magnetic field by means of the indicated procedure, said apparatus comprising:

- a cylindrical sensor element and an abutment/fixing element, such that the cylindrical sensor element experiences mechanical deformation when exposed to the d.c. magnetic field,
- a deformation sensing device configured for detecting the mechanical deformation of the cylindrical sensor element, and
- a processing unit configured for determining the intensity of the d.c. magnetic field based on the detected mechanical deformation of the cylindrical sensor element.

## PRIOR ART

In recent years, magnetic actuation in micro-electro-mechanical systems has received considerable attention. The main advantage is the ability to respond very fast and easy control of the magnetically expansive parts in range of its elastic limits during applied magnetic field.

Amorphous microwires, being among the softest magnetic materials, present outstanding peculiarities. Those with large and positive magnetostriction, exhibit bistable behavior with magnetization reversal through a giant Barkhausen jump originating in the propagation of a single-domain wall.

On the other hand, microwires with vanishing magnetostriction show giant magneto impedance (GMI) effect.

And both types show natural ferromagnetic resonance (NFMR) at microwave frequencies. Recently, a combination of fabrication methods has enabled the design of new bimagnetic multilayer microwire materials with novel properties, thus opening new generation of magnetic micro wires. All these properties, and many others, make amorphous magnetic microwires very attractive for unique technological applications, and also provide opportunities for fundamental micromagnetic studies due mainly to their simple magnetic domain structure. Magnetic microwires with disordered atomic structure belong to the large family of amorphous alloys. From the early development of amorphous metallic alloys, researchers have been looking to obtain amorphous microstructured materials with specific shapes and magnetic properties designed for applications, in particular, devices. Such developments have been running in a parallel way with the development of new techniques of fabrication. In this regard, for example, amorphous alloys are prepared, in the shape of ribbons, by rapid solidification techniques (usually directly labelled as metallic glasses), as thin films by sputtering methods, and as bulk materials, by optimized non-equilibrium techniques. Among these materials, amorphous thin films are readily integrated into thin-film and semiconductor technology but their magnetic character is not as soft as that of the others. Metallic glasses are commonly fabricated in ribbon form with specific applications in cores of small transformers or elements in sensor devices.

Some documents can be mentioned as prior art on this field:

H. Chiriac, T. A. Ovari, Gh. Pop, Firuta Barariu,"Amorphous glass-covered magnetic wires for sensing applications", Sensors and Actuators A 59, 243-251 (1997). This work describes magnetic characteristics such as the magnetization, switching field, coercive force, magnetic permeability and Large Barkhausen Effect in external stresses and in alternating magnetic field. The sensors described in this work use:

a) Large Barkhausen effect (premagnetization process) to detect the magnetic field
b) Matteuci effect (generation of an induced voltage across the ends of twisted wire in the presence of alternating magnetic field) to detect magnetic field
c) Magnetization and the switching field (field for change of magnetic orientation) to detect the mechanical stresses
d) circumferential magnetization to detect torsional stresses
e) giant magneto impedance effect to detect magnetic field

In other words magnetic properties and the Matteuci effect are considered or studied in this work for sensors applications.

The sensitivity of magneto-mechanical deformation of microwire on external magnetic field is not considered and is not included in this work.

Heung-Shik Lee, and Chongdu Cho, "Effect of Substrate Type on Overall Performance of Magnetostrictive Thin Film Cantilever Actuator for MEMS" in MEMS, NANO, and Smart Systems (ICMENS), 2009 Fifth International Conference on, p.41-44, (2009) and L. Mehnen, E. Kanuisas, J. Kosel, H. Pfutzner, T. Meydan, M. Vazquez, M. Rohn, A. Merlo, B. Marquaardt, "Magnetostrictive bilayer sensors". Proceedings of IEEE sensors 2004 : [IEEE Sensors 2004 Conference] ; pp 326-328

These publications are about magnetostrictive sensors actuators consisting of magnetostrictive and non-mangetostrictive layers (ribbons).

In the Mehnen et al. publication the sensor is prepared from two or more pieces of ribbons. It deals properly with a planar configuration, and exclusively in its fig. 4, a comment refers to the bending prevention by a circular symmetric bilayer wire. No experiments are referred on wires.

In the H.S. Lee article, the work deals again with planar configuration (i.e., films instead of microwire), the sensitive magnetostrictive layer being prepared by DC magnetron sputtering.

R. Sabol, M. Rovnak, P. Klein, M. Vazquez, and R. Varga, "Mechanical stress dependence of the switching field in amorphous microwires", IEEE Transaction on Magnetics, Vol. 51, No. 1, 2015.

It describes a device including a microwire with a magnetostrictive core is embedded in a composite lamella fixed on both ends

Applying a tensile force to the lamella (see Fig. 4) results in a bending, which may be detected by measuring magnetic properties of the microwire, caused by magnetoelastic coupling. The device can be used as a mechanical strain sensor, while other uses, such as magnetic field sensor, based on the principle of magnetic properties measurements (switching field, or magnetic bistability) are also mentioned.

## BRIEF DESCRIPTION OF THE INVENTION

A first object of the present invention is a procedure for measuring a d.c. magnetic field, comprising:

- providing a cylindrical device formed by a magnetostrictive core with a diameter ranging between 1 and 20 $\mu$m and a Pyrex coating with a thickness ranging between 2 and 10 $\mu$m, wherein at least one end of the cylindrical device is fixed,
- exposing the cylindrical device to the d.c. magnetic field, such that due to magnetostriction the cylindrical device experiences mechanical deformation
- measuring the mechanical deformation of the cylindrical device, and
- determining the intensity of the d.c. magnetic field by comparing the measured mechanical deformation with calibration data.

In a preferred embodiment, the magnetostrictive core is formed by an alloy comprising iron, silicon and boron, more preferably the magnetostrictive core consists of amorphous $Fe_{77.5}Si_{7.5}B_{15}$.

In a first operation mode, one end of the cylindrical device is fixed while its second end is connected on movable or free contact.

In a second operation mode, both ends of the cylindrical device are fixed.

A second object of the present invention is an apparatus for measuring a d.c. magnetic field, comprising:

- a cylindrical sensor element and an abutment/fixing element, wherein the sensor element comprises a cylindrical core of a magnetostrictive material with a diameter between 1 and 20 $\mu$m and a Pyrex coating with a thickness between 2 and 10 $\mu$m, and wherein at least one end of the cylindrical sensor element is fixed to the abutment/fixing element, such that the cylindrical sensor element experiences mechanical deformation when exposed to the d.c. magnetic field,
- a deformation sensing device configured for detecting the mechanical deformation of the cylindrical sensor element, and
- a processing unit configured for determining the intensity of the d.c. magnetic field based on the detected mechanical deformation of the cylindrical sensor element.

## BRIEF DESCRIPTION OF THE FIGURE

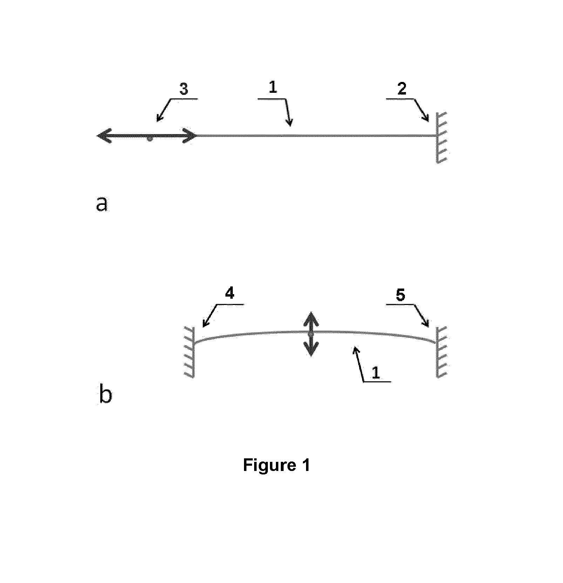

**Figure 1:** a) The first connection mode, where one end of wire (1) is at fixed contact (2) and second end is at the free (movable) contact (3). The bidirectional arrow marks the working regime in axial direction of wire. b) The second connection mode, where both ends of wire (1) are at fixed contacts (4, 5). The bidirectional arrow marks the working regime in perpendicular direction of wire.

## DETAILED DESCRIPTION OF THE INVENTION

Magneto mechanical microactuator with cylindrical shape works on the base of magnetostrictive expansion of ferromagnetic constituent. The body is a composite wire (cylinder) which works within the range of its elastic limit during applied magnetic field. Mechanical bending or magnetostrictive deformation in micrometer scale occurs during applied direct magnetic field.

For recapitulation, the body of the magneto mechanical microactuator is a composite cylinder consisting of microtubes. Large internal stresses on the glass/metal interface, and cylindrical shape are basic features necessary for the functionality of microactuator. A deformation is created when a magnetic field is applied along the axial direction of the composite cylinder due to magnetostrictive effect.

This device with the shape of wire offers two working regimes depending on connection mode:

i) In the first mode (Fig. 1a), one end of wire (1) is connected to the fixed contact (2), for example by solder, while its second end is connected to movable or free contact (3). The wire expands in axial direction after applied magnetic field because there is no opposite axial force due to free contact. Thus the motion is created on free movable contact.

ii) In the second mode(Fig. 1b), both ends of wire are connected to fixed contacts (4, 5), for example by solder. In the effort to expand in axial direction due to magnetostriction effect, opposite forces are acting from the fixed contacts. Large internal stresses also act on metal/glass interface. As a result, the wire shows a curvature. This effect is enhanced by large shape anisotropy of cylindrically shaped microdevice. Direction of created deformation, consequence of the magnetostrictive bending stresses, is the resultant force of these factors and is perpendicular to the axis of composite cylinder.

Both working regimes are reversible as shown by bidirectional arrows in Figure 1. With decreasing magnetic field intensity, the shape of the magneto mechanical device returns back to its initial position as it remains within its elastic limit. So, an alternating motion in both directions is created. The internal stresses on metal/glass interface play important role in that reversibility. The internal stresses are cylindrically distributed because of cylindrical shape of the metal/glass interface. Such distribution of internal stresses on metal/glass interface improves the elasticity of the wire mainly during reverse motion or in other words, they assure the return of the device to its initial shape during the decrease of magnetic field intensity.

This magneto mechanical device is protected from ambient corrosion atmosphere thanks to the anticorrosive nature of the Pyrex glass tube.

There can be deposited other tubes what can modify the functionality of the device in accordance with requirements.

**EXAMPLE**

A core of cylinder consists of amorphous $Fe_{77.5}Si_{7.5}B_{15}$ covered by Pyrex glass tube. It is prepared by modified Taylor-Ulitovsky method [(A.V. Ulitovsky, Pribory I Technika experimentu 3, 115 (1957)]. Large internal stresses are introduced mainly at glass/metal interface during preparation procedure. The Pyrex glass tube serves as a corrosion protection. The radius of amorphous $Fe_{77.5}Si_{7.5}B_{15}$ is $7\pm0.2\ \mu m$, the thickness of Pyrex glass tube is $9.5\pm0.2\ \mu m$ and the length of the composite cylinder is 1 cm. The internal stresses in glass/metal interface assure deformation in elastic limits of the composite when magnetic field intensity is changed.

A big advantage of this device is very easy preparation procedure due to its cylindrical shape. There is no need of complicated preparation procedure consisting of too many steps and complicated manipulation with special thin layers. The modified Taylor-Ulitovsky method enables the preparation of the final shape of the product in one single step. The quenching preparation procedure of such micro device takes a short time, less than one second. And finally, its cylindrical shape plays an important role in the final functionality of the microactuator.

The structural amorphous nature of the FeSiB metallic core is not necessary. This device will work also with polycrystalline FeSiB metallic core. The magnetostrictive character of the core is the only one requirement that should be satisfied for metallic core. Therefore, other magnetostrictive chemical compositions of metallic core fulfill the working conditions of this microdevice. For the technical parameters and working conditions determination the experiment was realized by Kerr microscope. A composite cylinder was installed in second connection mode. Direct magnetic field was applied for activation of magnetostriction effect in the second working regime. Visual observation showed that the magneto mechanical deformation is visible in the range (0-6 mT) of applied direct magnetic field. With increasing intensity of direct magnetic field the amplitude of magneto mechanical deformation increases from 0 to 2 $\mu$m. The opposite response is observed with the decrease of direct magnetic field intensity from 6 mT to 0 mT, the amplitude decreases from 2 $\mu$m to 0 $\mu$m. A number of similar experiments were performed and it is confirmed that in all cases the deformation amplitude is directly proportional to the applied direct magnetic field, which can be expressed as

$$A = k \times B,$$

where A is the amplitude of magneto mechanical deformation, B is the intensity of applied magnetic field, with parameters k = (0.3$\pm$0.02) for B in range 0-6 mT. Alternating direct magnetic field in range $\pm$6 mT caused mechanical oscillations.

**Claims**

1. Procedure for measuring a d.c. magnetic field, comprising:

   - providing a cylindrical device formed by a magnetostrictive core with a diameter ranging between 1 and 20 $\mu$m and a Pyrex coating with a thickness ranging between 2 and 10 $\mu$m, wherein at least one end of the cylindrical device is fixed,
   - exposing the cylindrical device to the d.c. magnetic field, such that due to magnetostriction the cylindrical device experiences mechanical deformation

- measuring the mechanical deformation of the cylindrical device, and
- determining the intensity of the d.c. magnetic field by comparing the measured mechanical deformation with calibration data.

2. Procedure for measuring a d.c. magnetic field according to claim 1, wherein the magnetostrictive core is formed by an alloy comprising iron, silicon and boron.

3. Procedure for measuring a d.c. magnetic field according to claim 2, wherein the magnetostrictive core consists of amorphous $Fe_{77.5}Si_{7.5}B_{15}$.

4. Procedure for measuring a d.c. magnetic field according to anyone of claims 1 to 3, wherein one end of the cylindrical device is fixed while its second end is connected on movable or free contact.

5. Procedure for measuring a d.c. magnetic field according to anyone of claims 1 to 3, wherein both ends of the cylindrical device are fixed.

6. Apparatus for measuring a d.c. magnetic field, comprising:

- a cylindrical sensor element and an abutment/fixing element, wherein the sensor element comprises a cylindrical core of a magnetostrictive material with a diameter between 1 and 20 μm and a Pyrex coating with a thickness between 2 and 10 μm, and wherein at least one end of the cylindrical sensor element is fixed to the abutment/fixing element, such that the cylindrical sensor element experiences mechanical deformation when exposed to the d.c. magnetic field,
- a deformation sensing device configured for detecting the mechanical deformation of the cylindrical sensor element, and
- a processing unit configured for determining the intensity of the d.c. magnetic field based on the detected mechanical deformation of the cylindrical sensor element.

a

b

Figure 1

Europäisches Patentamt

European Patent Office

Office européen des brevets

**EUROPEAN SEARCH REPORT**

Application Number

EP 15 19 5921

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DOMINGUEZ M ET AL: "Microwave response of amorphous microwires: magnetoimpedance and ferromagnetic resonance", JOURNAL OF MAGNETISM AND MAGNETIC MATERIALS, ELSEVIER SCIENCE PUBLISHERS, AMSTERDAM, NL, vol. 249, no. 1-2, 1 August 2002 (2002-08-01), pages 117-121, XP027322677, ISSN: 0304-8853 [retrieved on 2002-08-01] * abstract * * Sections 1 and 2 * | 1-4,6 | INV. G01R33/06 G01R33/18 |
| X | IÃ+-IGO LIBERAL ET AL: "Fe-Rich Ferromagnetic Wires for Mechanical-Stress Self-Sensing Materials", IEEE TRANSACTIONS ON MICROWAVE THEORY AND TECHNIQUES, IEEE SERVICE CENTER, PISCATAWAY, NJ, US, vol. 60, no. 9, 1 September 2012 (2012-09-01), pages 2752-2759, XP011458817, ISSN: 0018-9480, DOI: 10.1109/TMTT.2012.2205938 * abstract; figure 5 * * Sections I and III * | 1-6 | |
| X | GONZALEZ J ET AL: "Magnetoelastic Behavior of Glass-Covered Amorphous Ferromagnetic Microwire", IEEE TRANSACTIONS ON MAGNETICS, IEEE SERVICE CENTER, NEW YORK, NY, US, vol. 33, no. 3, 1 May 1997 (1997-05-01), XP011031297, ISSN: 0018-9464 * abstract * * Section I and II * | 1-6 | TECHNICAL FIELDS SEARCHED (IPC) G01R |

-/--

The present search report has been drawn up for all claims

| Place of search | Date of completion of the search | Examiner |
|---|---|---|
| Munich | 13 May 2016 | Böhm-Pélissier, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

Application Number

EP 15 19 5921

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2011/291649 A1 (HONKURA YOSHINOBU [JP] ET AL) 1 December 2011 (2011-12-01) <br> * paragraph [0006] - paragraph [0010] * <br> * abstract; figures 1-4 * <br> ----- | 1-6 | |

TECHNICAL FIELDS
SEARCHED      (IPC)

The present search report has been drawn up for all claims

| Place of search | Date of completion of the search | Examiner |
|---|---|---|
| Munich | 13 May 2016 | Böhm-Pélissier, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 15 19 5921

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2016

| Patent document cited in search report | Publication date | Patent family member(s) | Publication date |
|---|---|---|---|
| US 2011291649 A1 | 01-12-2011 | CN 102334040 A | 25-01-2012 |
|  |  | EP 2402778 A1 | 04-01-2012 |
|  |  | JP 4835805 B2 | 14-12-2011 |
|  |  | KR 20110120316 A | 03-11-2011 |
|  |  | US 2011291649 A1 | 01-12-2011 |
|  |  | WO 2010097932 A1 | 02-09-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **H. CHIRIAC ; T. A. OVARI ; GH. POP ; FIRUTA BARARIU.** Amorphous glass-covered magnetic wires for sensing applications. *Sensors and Actuators A,* 1997, vol. 59, 243-251
- **HEUNG-SHIK LEE ; CHONGDU CHO.** Effect of Substrate Type on Overall Performance of Magnetostrictive Thin Film Cantilever Actuator for MEMS. *MEMS, NANO, and Smart Systems (ICMENS), 2009 Fifth International Conference,* 2009, 41-44
- **L. MEHNEN ; E. KANUISAS ; J. KOSEL ; H. PFUTZNER ; T. MEYDAN ; M. VAZQUEZ ; M. ROHN ; A. MERLO ; B. MARQUAARDT.** Magnetostrictive bilayer sensors. *Proceedings of IEEE sensors 2004 : [IEEE Sensors 2004 Conference,* 2004, 326-328
- **R. SABOL ; M. ROVNAK ; P. KLEIN ; M. VAZQUEZ ; R. VARGA.** Mechanical stress dependence of the switching field in amorphous microwires. *IEEE Transaction on Magnetics,* 2015, vol. 51 (1
- **A.V. ULITOVSKY.** *Pribory I Technika experimentu,* 1957, vol. 3, 115